# EUROPÄISCHE PATENTSCHRIFT

(11) **EP 2 188 841 B1**
(45) Veröffentlichungstag und Bekanntmachung des Hinweises auf die Patenterteilung: **10.10.2018**
(21) Anmeldenummer: 08785631.6
(22) Anmeldetag: 20.08.2008
(51) Int. Cl.: H01L 29/22, H01L 29/76

(54) **ELEKTRONISCHES BAUELEMENT, VERFAHREN ZU SEINER HERSTELLUNG UND SEINE VERWENDUNG**
ELECTRONIC COMPONENT, METHODS FOR THE PRODUCTION THEREOF, AND USE THEREOF
COMPOSANT ÉLECTRONIQUE, PROCÉDÉ POUR SA PRODUCTION ET SON UTILISATION

(30) Priorität: 12.09.2007 DE 102007043360
(43) Veröffentlichungstag der Anmeldung: 26.05.2010
(73) Patentinhaber: Karlsruher Institut für Technologie, 76131 Karlsruhe (DE)
(72) Erfinder: HAHN, Horst, 64342 Seeheim-Jugenheim (DE)
(74) Vertreter: Gärtner, Stephan
(86) Internationale Anmeldenummer: PCT/EP2008/006818
(87) Internationale Veröffentlichungsnummer: WO 2009/036856

(56) Entgegenhaltungen:
- DE-C1- 19 952 447
- US-A1- 2006 118 853
- US-A1- 2007 064 468
- US-A1- 2007 132 052
- MIROIU F ET AL: "Fabrication of low dimensional structures of ZnSe and ZnO by thermal and mechanical methods" PHYSICA STATUS SOLIDI C WILEY-VCH GERMANY, Nr. 4, 2006, Seiten 1066-1069, XP002504180 ISSN: 1610-1634
- HUANG G-W ET AL: "One-pot synthesis and characterization of high-quality CdSe/ZnX (X=S, Se) nanocrystals via the CdO precursor" JOURNAL OF CRYSTAL GROWTH, ELSEVIER, AMSTERDAM, NL, Bd. 265, Nr. 1-2, 15. April 2004 (2004-04-15), Seiten 250-259, XP004501009 ISSN: 0022-0248

## Beschreibung

Die Erfindung betrifft ein elektronisches Bauelement mit einer Schicht aus Nanopartikeln, ein Verfahren zu seiner Herstellung und seine Verwendung.

Die Durchstimmbarkeit von strukturellen und funktionellen Eigenschaften wurde in den vergangenen Jahren für metallische Nanostrukturen in Form von dünnen Filmen und nanoporösen Strukturen, d.h. in Strukturen mit extrem großem Oberflächen-zu-Volumen-Verhältnis, nachgewiesen.

Die grundlegende Idee der Durchstimmbarkeit der elektronischen Struktur und der Eigenschaften von nanokristallinen Materialien stammt von H. Gleiter, J. Weissmüller, O. Wollersheim und R. Würschum, die sie zuerst in Nanocrystalline Materials: A way to solids with tunable electronic structures and properties?, Acta Mater. 49 (2001), 737-745, veröffentlichten.

Aus der DE 199 52 447 C1 und aus J. Weissmüller, R. N. Viswanath, D. Kramer, P. Zimmer, R. Würschum und H. Gleiter, Charge-Induced Reversible Strain in a Metal, Science 300 (2003), 312-315, ist bekannt, dass reversible Längenänderungen von nanoporösem Gold durch das Aufbringen von elektrischen Ladungen an der Grenzfläche eines Elektrolyten zu den metallischen Nanostrukturen in einer Doppelschicht möglich werden.

C. Bansal, S. Sarkar, A.K. Mishra, T. Abraham, C. Lemier und H. Hahn zeigten in Electronically tunable conductivity of a nanoporous Au-Fe alloy, Scripta Materialia 56 (2007), 705-708, dass reversible Änderungen des elektrischen Widerstands von nanoporösem Gold bzw. von nanoporösen Au-Fe-Legierungen durch das Aufbringen von elektrischen Ladungen an der Grenzfläche eines Elektrolyten zu den metallischen Nanostrukturen in einer Doppelschicht möglich werden. Hierbei wurden Änderungen des elektrischen Widerstands im Bereich von einigen Prozent bei angelegten Ladungsdichten von etwa 50 µC/cm² beobachtet.

Derselbe Effekt in derselben Größenordnung wurde von M. Sagmeister, U. Brossmann, S. Landgraf, and R. Würschum, in Electrically Tunable Resistance of a Metal, Phys. Rev. Lett. 96 (2006), 156601 für nanoporöses Pt nachgewiesen.

US 2006/118853 A1 (TAKATA MASAAKI [JP] ET AL) 8. Juni 2006 beschreibt ein elektronisches Bauelement mit Nanopartikeln

Das Konzept der Durchstimmbarkeit der elektrischen Leitfähigkeit ist bei Halbleitern wie z.B. Si und Ge als so genanntes electric *field gating* seit Jahrzehnten etabliert und bildet die Basis ihrer Anwendung in der Elektronik. Die grundlegende Struktur besteht hierbei in einer Anordnung aus *Source* und *Drain,* die über das halbleitende Material miteinander verbunden sind, sowie einer Gate-Elektrode, die über ein geeignetes Gate-Oxid vom Halbleiter getrennt ist. Die Leitfähigkeit der halbleitenden Schicht wird mittels einer an das Gate angelegten Gate-Spannung über einen weiten Bereich variiert.
Bei Oxiden ist die durch Grenzflächenladungen zu beeinflussbare Zone, die Raumladungszone, sehr viel größer als bei den oben genannten Metallen, aber im Vergleich zu Halbleitern, deren Ladungsträgerdichte geringer ist als die der leitfähigen Oxide, ist die Raumladungszone kleiner. Dennoch gibt es bisher kaum Untersuchungen zur Nutzung von Oxiden als durchstimmbare Materialien.
Im Bereich der funktionellen Eigenschaften von leitenden Oxiden konnten R. Misra, M. McCarthy, und A. F. Hebard in Electric field gating with ionic liquids, Applied Physics Letters 90, (2007) 052905, die elektrische Leitfähigkeit einer dünnen Indiumoxid-Schicht in einer ionischen Flüssigkeit steuern und Änderungen der Sheet-Impedance von mehr als 4 Größenordnungen messen.
Ausgehend hiervon ist es die Aufgabe der vorliegenden Erfindung, ein elektronisches Bauelement, ein Verfahren zu seiner Herstellung und seine Verwendung vorzuschlagen, die die vorher genannten Nachteile und Einschränkungen nicht aufweisen.

Insbesondere soll ein elektronisches Bauelement bereitgestellt werden, das die reversible Durchstimmbarkeit des elektrischen Widerstands in einer Vielzahl von nanoporösen Strukturen mittels einer hieran angelegten Gate-Spannung über viele Größenordnungen ermöglicht.
Diese Aufgabe wird im Hinblick auf das Element durch die Merkmale des Anspruchs 1, im Hinblick auf das Verfahren durch die Verfahrensschritte des Anspruchs 6 oder 7 und im Hinblick auf die Verwendung durch den Anspruch 10 gelöst. Die Unteransprüche beschreiben jeweils vorteilhafte Ausgestaltungen der Erfindung.
Ein erfindungsgemäßes elektronisches Bauelement enthält zunächst zwei Elektroden, die als Source und Drain für das Bauelement fungieren. Zwischen diesen beiden Elektroden befindet sich eine Schicht aus Nanopartikeln, wobei die Nanopartikeln aus einer elektrisch leitenden oder halbleitenden Verbindung eines Metalls mit einem Element aus der VI. Hauptgruppe des Periodensystems der chemischen Elemente, bevorzugt einem Oxid, einem Sulfid oder einem Selenid bestehen.
Hierbei ist entscheidend, dass die Dimensionen der überwiegenden Anzahl der Nanopartikeln zwischen dem 0,1-fachen und dem 10-fachen der Abschirmlänge der elektrisch leitfähigen Verbindung liegen.
Ein erfindungsgemäßes elektronisches Bauelement enthält weiterhin ein Dielektrikum, das zumindest mit einem Teil der Nanopartikel aus der Schicht über mindestens eine gemeinsame Grenzfläche verfügt.
Die Nanopartikel innerhalb der Schicht weisen bevorzugt Partikelgrößen im Bereich von 5 nm bis zu 500 nm auf. Zwischen den Nanopartikeln innerhalb der Schicht befinden sich Poren, die bevorzugt eine Porengrößenverteilung im Bereich von 5 nm bis zu 500 nm aufweisen.

Die Nanopartikel bestehen vorzugsweise aus einem elektrisch leitfähigen Metalloxid, Metallsulfid oder Metallselenid. Besonders bevorzugt sind hierbei transparente leitende Oxide, insbesondere aus Indium-Zinn-Oxid (ITO), aus fluordotiertem Zinn(IV)oxid (SnO₂: F; FTO), aus antimondotiertem Zinn(IV)oxid (SnO₂:Sb, ATO) oder aus aluminiumdotiertem Zinkoxid (AZO). Insbesondere bei erhöhten Temperaturen eignen sich Nanopartikel aus Zinkoxid, Titandioxid, Zinksulfid oder Cadmiumsulfid.

In einer besonderen Ausgestaltung liegen die Nanopartikel als gesinterte nanoporöse Volumenstrukturen vor, die bei moderaten Temperaturen gesintert wurden. Die Porenstruktur weist ausgeprägte Korngrenzen/Grenzflächen zwischen den Partikeln oder Körnern der anorganischen Phase auf.

In einer weiteren Ausgestaltung liegen die Nanopartikel in Form von locker zusammenhängenden porösen Strukturen vor, die nur wenig ausgeprägte Grenzflächen zwischen sich berührenden Partikeln der anorganischen Phase besitzen.

In einer bevorzugten Ausgestaltung enthält das erfindungsgemäße elektronische Bauelement eine Schicht aus Nanopartikeln, die in Form einer planaren Struktur auf das Dielektrikum aufgebracht ist. Das Dielektrikum selbst liegt in Form einer planaren dielektrischen Schicht vor, die ihrerseits auf einer planaren elektrisch leitfähigen Schicht aufgebracht ist. Zwischen der dünnen Schicht aus Nanopartikeln der leitenden oder halbleitenden Verbindung und einem geeigneten Elektrolyten bilden sich daher ebene Grenzflächen zwischen der Verbindung und dem Dielektrium aus.

In einer weiteren Ausgestaltung enthält das erfindungsgemäße elektronische Bauelement eine Schicht aus Nanopartikeln, die auf ein elektrisch isolierendes Substrat aufgebracht ist. Das Dielektrikum befindet sich auf der Oberfläche der Schicht aus Nanopartikeln und steht in direktem Kontakt mit einer Steuerelektrode. Vorzugsweise wurde das Dielektrikum (Gate-Dielektrik-Schicht) als Dispersion aufgebracht und liegt daher konform an die raue Oberfläche der Funktionsschicht an. Damit ist sichergestellt, dass der erfindungsgemäße Effekt auch bei rauen Oberflächen maximal wird.

In einer besonders bevorzugten Ausgestaltung enthält das erfindungsgemäße elektronische Bauelement ein bi-kontinuierliches, interpenetrierendes Komposit-Netzwerk, das aus halbleitenden oder leitenden Nanopartikeln und einem geeigneten Elektrolyten als Dielektrikum besteht und eine Anordnung aus komplex geformten zufälligen Grenzflächen zwischen dem Elektrolyten und den einzelnen Nanopartikeln ausbildet. Auch hier befindet sich das Dielektrikum in Kontakt mit einer Steuerelektrode. Der Elektrolyt selbst kann in einer flüssigen oder in einer festen Phase vorliegen.

An der Grenzfläche zwischen Elektrolyt und den Nanopartikeln lassen sich elektrische Ladungen durch Anlegen eines Potentials aufbringen. Die elektrischen Ladungen werden durch Änderung des Potentials reversibel variiert, wodurch sich die elektrische Leitfähigkeit der Schicht aus Nanopartikeln reversibel verändern lässt. Alle Oberflächen der Nanopartikel befinden sich in direktem Kontakt zum Elektrolyten und können damit alle Oberflächen mit Ladungen belegen. Auf diese Weise wird ein besonders hoher Effekt erzielt, der eine Durchstimmbarkeit der Schicht über mehrere Größenordnungen ermöglicht. Die Strukturdimensionen der Nanopartikel müssen dabei in der Größenordnung der Abschirmlänge liegen, damit sich die elektrische Leitfähigkeit der Oxidphase merklich variieren lässt.

Um die Kapazitäten des vorliegenden elektronischen Bauelements zu optimieren, sollten, wie auch in Bauelementen erforderlich, nur kleine Flächen verwendet werden. Auf diese Weise lassen sich die Schaltzeiten des Bauelements möglichst kurz halten.

Zum Betrieb eines erfindungsgemäßen elektronischen Bauelements wird ein Potential zwischen der Schicht aus Nanopartikeln und einer Gegenelektrode angelegt. Diese Anordnung wurde bereits als funktionsfähige Einheit realisiert und die reversible Änderung der elektrischen Leitfähigkeit ließ sich über mehrere Größenordnungen nachweisen.

Die Strukturen eines erfindungsgemäßen elektronischen Bauelements können durch konventionelle Schichtpräparationsverfahren synthetisiert werden und anschließend mit einem flüssigen oder festen Elektrolyten (Dielektrikum) belegt werden.

Als Schichtpräparationsverfahren kommen insbesondere die folgenden Verfahren in Frage:
(1) Sputtern oder Vakuum-Aufdampfverfahren;
(2) Spin-Coating oder Druckverfahren, bevorzugt Siebdruckverfahren oder Ink-Jet-Drucken, von Dispersionen der anorganischen Nanopartikel mit anschließendem Sinterschritt;
(3) Spin-Coating oder Druckverfahren, bevorzugt Siebdruckverfahren oder Ink-Jet-Drucken, von Dispersionen der anorganischen Nanopartikel mit Elektrolyt mit einem anschließenden Temperschritt.

In den Verfahren (1) und (2) wird der flüssige oder feste Elektrolyt nach der Schichtherstellung und einem ggf. erforderlichen Sinter- oder Temperschritt als weitere Schicht auf die dünne Schicht der anorganischen Phase aufgebracht und anschließend mit einer Elektrode mit großer Oberfläche versehen.

In Verfahren (3) werden die Nanopartikel der anorganischen Phase direkt in einem flüssigen Elektrolyten dispergiert und auf ein geeignetes Substrat durch Spin-Coating oder ein Druckverfahren, bevorzugt Siebdruckverfahren oder Ink-Jet-Drucken, aufgebracht. Ein Temperschritt, der mit den eingesetzten Substraten, dem gewählten Druckverfahren und dem Elektrolyten verträglich ist, kann zum Erzeugen einer optimalen elektrischen Leitfähigkeit über die Grenzflächen der anorganischen Phase angeschlossen werden.

An Stelle eines flüssigen Elektrolyten kann auch ein Elektrolyt verwendet werden, der vor seiner Trocknung flüssig ist und durch Trocknung fest wird. Bei Einsatz eines derartigen Elektrolyten, der durch Trocknung fest wird, kann die Schrumpfung der Elektrolytphase dazu dienen, um die anorganischen Nanopartikel zusammenzuziehen und auf diese Weise eine höhere elektrische Leitfähigkeit zu erhalten.

Erfindungsgemäße elektronische Bauelemente lassen sich insbesondere als Dioden, Transistoren, Spannungsinverter oder als Sensoren verwenden.

Der Einsatz von nanokristallinen funktionellen Partikeln aus einer Verbindung eines Metalls mit einem Element aus der VI. Hauptgruppe des Periodensystems, d.h. insbesondere Oxide, Sulfide und Selenide, in Kombination mit der Nutzung der Durchstimmbarkeit von Materialeigenschaften durch reversible Aufladung in einem Elektrolyten führt zu neuen Möglichkeiten für funktionelle Bauelemente im Bereich der druckbaren Elektronik. Besonders vorteilhaft für die druckbare Elektronik ist der Einsatz eines druckfähigen Elektrolyt-Nanopartikel-Gemischs.

Die Erfindung wird im Folgenden anhand von Ausführungsbeispielen und den Figuren näher erläutert. Hierbei zeigen
- **Fig. 1**: Elektronische Bauelemente mit einem leitfähigen Oxid (Stand der Technik) **a)** ohne bzw. **b)** mit Elektrolyt.
- **Fig. 2**: Erfindungsgemäßes elektronisches Bauelement mit einer Schicht aus Nanopartikeln in Form einer planaren Struktur auf einem Dielektrikum, das in Form einer planaren dielektrischen Schicht vorliegt.
- **Fig. 3**: Erfindungsgemäßes elektronisches Bauelement, bei dem sich das Dielektrikum auf der Oberfläche der Schicht aus Nanopartikeln befindet.
- **Fig. 4**: Erfindungsgemäßes elektronisches Bauelement, bei dem das Dielektrikum in Form eines Elektrolyten vorliegt, der mit den Nanopartikeln der Schicht ein interpenetrierendes Netzwerk ausbildet.
- **Fig. 5**: Änderung des elektrischen Widerstands zweier erfindungsgemäßer elektronischer Bauelemente mit der Zeit bei Variation der Gate-Spannung.
- **Fig. 6**: **a)** Strom-Spannungs-Charakteristik, **b)** Source-Charakteristik und **c)** Drain-Charakteristik eines erfindungsgemäßen elektronischen Bauelements.

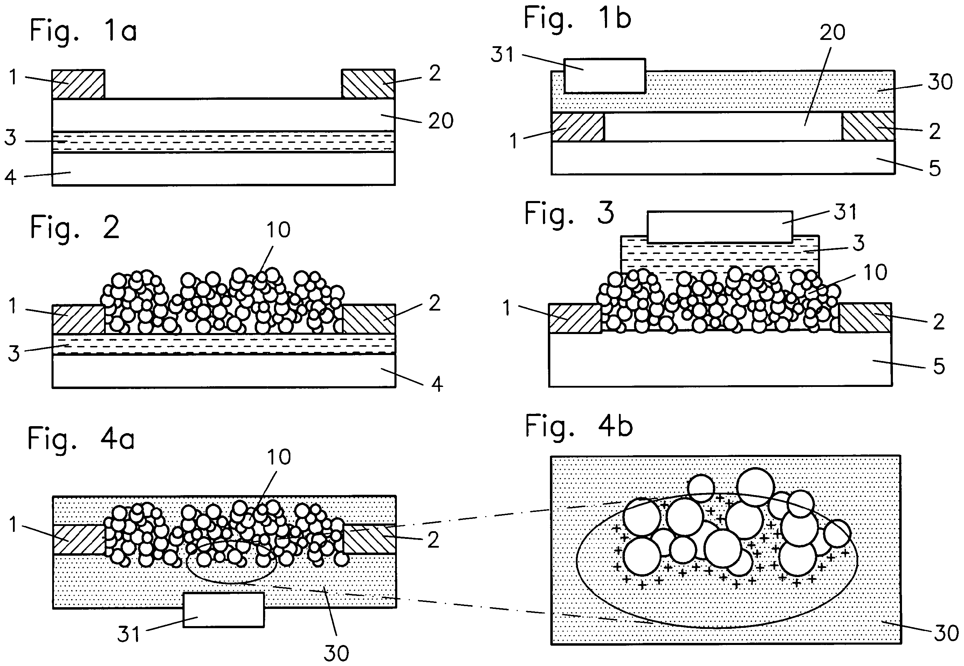

In **Fig. 1 a)** **und b)** sind elektronische Bauelemente dargestellt, die aus dem Stand der Technik bekannt sind und die jeweils ein halbleitendes oder leitendes Metalloxid umfassen.

In dem in **Fig. 1a****)** dargestellten elektronischen Bauelement wurde ein leitfähiges Metalloxid in Form eines dünnen Oxidfilms **20** auf einer dielektrischen Schicht **3**, die als Gate fungiert und die auf einer leitfähigen Elektrode **4** aus hoch dotiertem Silizium oder Metall aufgebracht ist, abgeschieden. Die Elektroden **1, 2** für Source und Drain sind direkt auf dem Oxidfilm **20** aufgebracht. Durch Anlegen einer Gate-Spannung an die dielektrische Schicht **3** wird die elektrische Leitfähigkeit des Oxidfilms **20** variiert.

In dem in **Fig. 1b****)** dargestellten elektronischen Bauelement ist die dielektrische Schicht **3** aus **Fig. 1a****),** die als Gate fungiert, durch einen festen oder flüssigen Elektrolyten **30** ersetzt. Daher weist dieses Bauelement an Stelle der leitfähigen Elektrode **4** (Gate-Elektrode) eine Steuerelektrode **31** auf, die eine große Oberfläche besitzen muss, um dem Elektrolyten **30** möglichst schnell Ladungen zur Verfügung stellen zu können. Auch hier stehen die Elektroden **1, 2** für Source und Drain direkt mit dem Oxidfilm 20 in Verbindung. Das Bauelement befindet sich auf einem elektrisch nicht leitfähigen Substrat 5.

Die **Fig. 2 bis 4** zeigen drei Ausgestaltungen von erfindungsgemäßen elektronischen Bauelementen, deren aktive Schicht jeweils aus einer nanokristallinen Oxidschicht 10 aus einem halbleitenden oder leitenden Metalloxid besteht.

In **Fig. 2** ist ein erfindungsgemäßes elektronisches Bauelement dargestellt. Hierbei wurde eine elektrisch leitfähige nanokristalline Oxidschicht **10** auf einer dielektrischen Schicht **3,** die als Gate fungiert und die sich auf einer leitfähigen Elektrode **4** aus hoch dotiertem Silizium oder Metall befindet, durch ein Druckverfahren mit oder ohne anschließenden Sinterschritt aufgebracht. Die Elektroden **1, 2** für Source und Drain stehen sich in direktem Kontakt mit der nanokristallinen Oxidschicht **10.** Durch Anlegen einer Gate-Spannung an die dielektrische Schicht **3** wird die elektrische Leitfähigkeit der nanokristallinen Schicht **10** variiert.

**Fig. 3** zeigt eine weitere Ausgestaltung eines erfindungsgemäßen elektronischen Bauelements. Hierbei befindet sich die elektrisch leitfähige nanokristalline Oxidschicht 10 auf einem elektrisch nicht leitfähigen Substrat **5** sowie in direktem Kontakt mit den Elektroden **1, 2** für Source und Drain. Die dielektrische Schicht **3,** die das Gate fungiert, wurde jedoch als Dispersion auf die Oberfläche der nanokristallinen Schicht **10** aufgebracht und liegt deshalb konform an der rauen Oberfläche der nanokristallinen Schicht **10** an. Damit ist sichergestellt, dass der zugrunde liegende Effekt auch bei rauen Oberflächen maximal wird. Die dielektrische Schicht **3** befindet sich im direkten Kontakt mit einer Gate-Elektrode **31.**

**Fig. 4a****)** zeigt eine besonders vorteilhafte Ausgestaltung eines erfindungsgemäßen Bauelements. Hierbei befindet sich eine elektrisch leitfähige nanokristalline Oxidschicht **10** im direkten Kontakt mit den Elektroden **1, 2** für Source und Drain und die dielektrische Schicht **3** aus **Fig. 2****,** die als Gate fungiert, ist durch einen festen oder flüssigen Elektrolyten **30** ersetzt. Der Elektrolyt **30** steht in direktem Kontakt mit einer Steuerelektrode **31.** Auch in dieser Ausgestaltung muss die Steuerelektrode **31** eine hohe Oberfläche besitzen.

Die Änderung der Leitfähigkeit der nanokristallinen Oxidschicht **10** wird durch eine kleine Spannung zwischen der Steuerelektrode 31 und der nanokristallinen Schicht **10** zwischen den Elektroden 1, 2 für Source und Drain bewirkt. Wie in der Vergrößerung in **Fig. 4b****)** für ein Beispiel mit positiven Ladungen dargestellt, werden an den Oberflächen der Oxidpartikel positive Ladungen erzeugt. Diese Ladungen sind für die Veränderung der Leitfähigkeit der nanokristallinen Oxidschicht 10 verantwortlich.

Die in **Fig. 4** beispielhaft beschriebene Struktur kann hergestellt werden, indem zwischen den beiden Elektroden **1, 2,** die als Source und Drain fungieren, ein nanopartikulärer Film **10** durch ein Druckverfahren, insbesondere mittels Siebdruck oder Inkjet, hergestellt, anschließend gesintert, um die leitfähigen Brücken zwischen den einzelnen Nanopartikeln zu erzeugen, und dann mit einem festen oder flüssigen Elektrolyten **30** infiltriert wird. Durch das Anlegen einer Steuerspannung zwischen den Elektroden **1, 2** für Source und Drain sowie der Steuerelektrode **31** lässt sich dann das Element schalten.

In einer alternativen Ausgestaltung werden die Nanopartikel direkt in einem Elektrolyten, der zum Zeitpunkt des Dispergierens und Druckens flüssig ist und später entweder aushärtet oder flüssig bleibt, dispergiert und anschließend in einem Schritt durch ein Druckverfahren auf ein Substrat aufgebracht. Während des Druck- und Trocknungsvorgangs werden leitfähige Kontakte zwischen den Nanopartikeln des leitfähigen Oxids erzeugt und das erfindungsgemäße Bauelement ist sofort oder nach nur moderater Temperaturbehandlung funktionsfähig. Diese Art der Herstellung eignet sich insbesondere für den Einsatz in der druckbaren Elektronik.

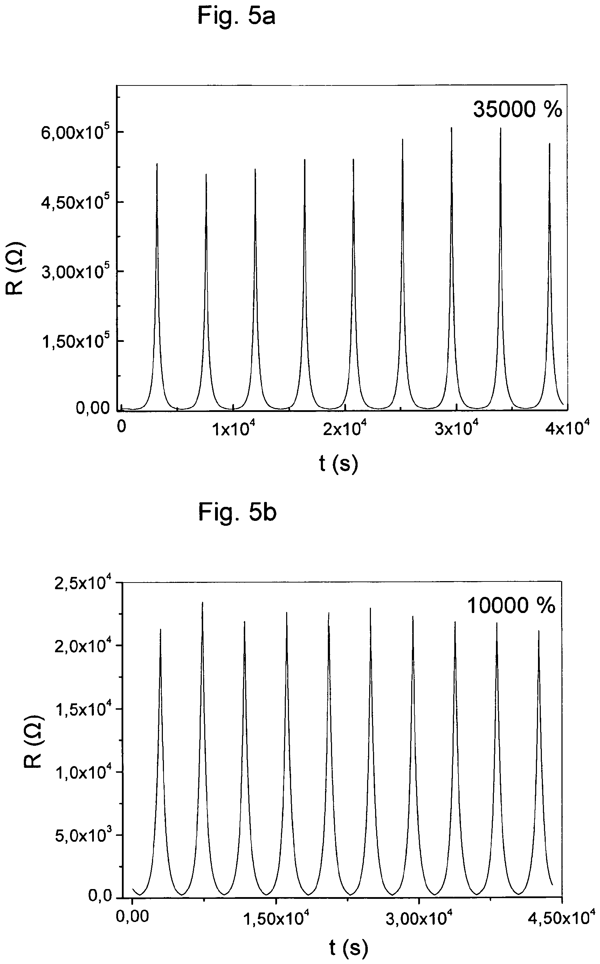

**Fig. 5** zeigt den elektrischen Widerstand von zwei verschiedenen erfindungsgemäßen Bauelementen als Funktion der Zeit bei Variation der zwischen der Steuerelektrode **31** und der elektrisch leitfähigen nanokristallinen Schicht 10 als Elektrode angelegten Steuerspannung zwischen -0,3 V und + 0,8 V **(****Fig. 5a****))** bzw. zwischen -0,25 V und + 0,85 V (Fig. 5b)), die jeweils mit einer Geschwindigkeit von 0,5 mV/s (Scan) variiert wurden. Beide Bauelemente wiesen eine Ausgestaltung gemäß **Fig. 4** auf. Diesen Messergebnissen ist zu entnehmen, dass sich der elektrische Widerstand der beiden Bauelemente durch einfache Variation der Steuerspannung um einen Faktor 350 (= 35 000%; **Fig. 5a****)** bzw. 100 (= 10 000%; **Fig. 5b****)** verändern lässt. Dieser Effekt liegt damit um mehrere Größenordnungen über den in C. Bansal et al., Scripta Materialia 56 (2007), 705 ff, beschriebenen reversiblen Änderungen des elektrischen Widerstands von nanoporösem Gold bzw. von nanoporösen Au-Fe-Legierungen.

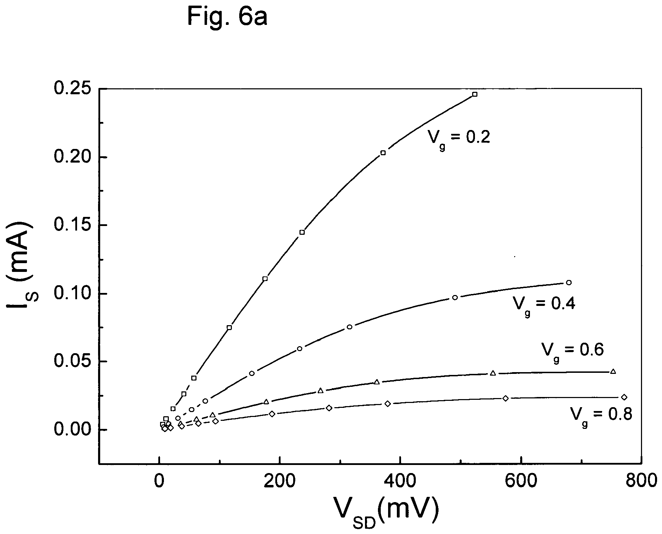

**Fig. 6a****)** zeigt die Strom-Spannungs-Charakteristik eines erfindungsgemäßen Bauelements und belegt, dass sich dieses als Transistor betreiben lässt.

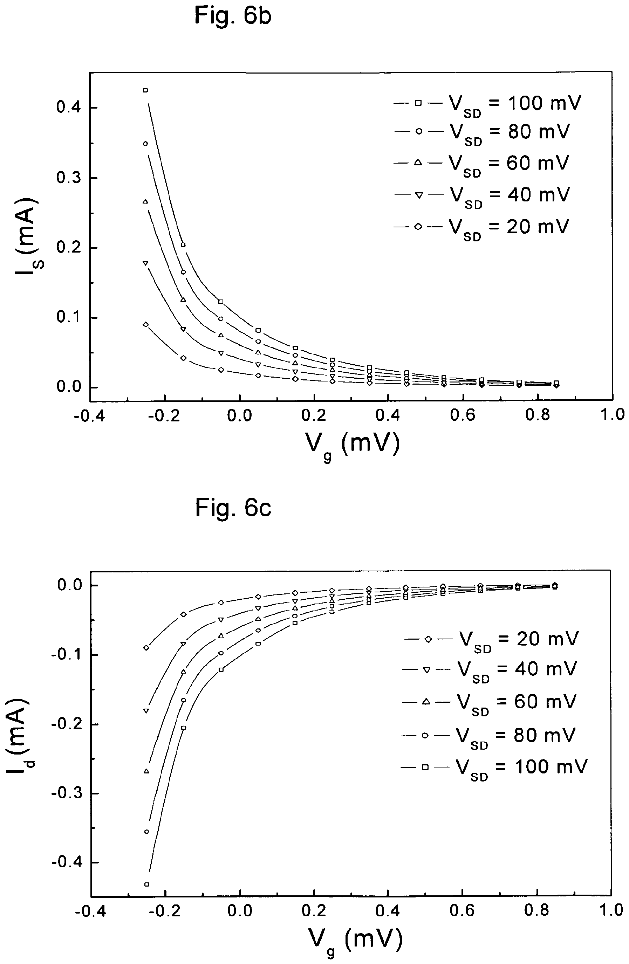

**Fig. 6b)** und **Fig. 6c****)** zeigen die Source-Charakteristik bzw. die Drain-Charakteristik eines erfindungsgemäßen Bauelements. Der Vergleich dieser beiden Charakteristiken bestätigt, dass die in **Fig. 5** gezeigten Effekte nicht auf Leckströme zwischen den Elektroden **1, 2** zurückgehen.

## Patentansprüche

1. Elektronisches Bauelement, umfassend
zwei Elektroden **(1,2),** zwischen denen sich eine Schicht (**10**) aus Nanopartikeln, die aus einer elektrisch leitfähigen Verbindung eines Metalls mit einem Element aus der VI. Hauptgruppe des Periodensystems bestehen, befindet, wobei die Dimensionen der überwiegenden Anzahl der Nanopartikel zwischen dem 0,1-fachen und dem 10-fachen der Abschirmlänge der elektrisch leitfähigen Verbindung liegen, und ein Dielektrikum, das zumindest mit einem Teil der Nanopartikel aus der Schicht **(10)** mindestens eine gemeinsame Grenzfläche ausbildet, **dadurch gekennzeichnet,**
**dass** die Schicht (10) durch einen gedruckten nanopartikulären Film gebildet wird, das Dielektrikum in Form eines festen oder flüssigen Elektrolyten **(30)** vorliegt, der mit den Nanopartikeln der Schicht **(10)** ein interpenetrierendes Netzwerk ausbildet und in Kontakt mit einer Steuerelektrode **(31)** steht.

2. Elektronisches Bauelement mit einer Schicht **(10)** aus Nanopartikeln nach Anspruch 1, wobei die Nanopartikel Partikelgrößen von 5 nm bis zu 500 nm aufweisen und sich zwischen den Nanopartikeln in der Schicht **(10)** Poren befinden, die eine Porengrößenverteilung von 5 nm bis zu 500 nm aufweisen.

3. Elektronisches Bauelement nach Anspruch 1 oder 2 mit Nanopartikeln aus einem elektrisch leitfähigen Metalloxid, Metallsulfid oder Metallselenid.

4. Elektronisches Bauelement nach Anspruch 3 mit Nanopartikeln aus Indium-Zinnoxid, fluor- oder antimondotiertem Zinn(IV)-oxid oder aluminiumdotiertem Zinkoxid.

5. Elektronisches Bauelement nach Anspruch 3 mit Nanopartikeln aus Zinkoxid, Titandioxid, Zinksulfid oder Cadmiumsulfid.

6. Verfahren zur Herstellung eines elektronischen Bauelements nach einem der Ansprüche 1 bis 5, bei dem die Strukturen eines erfindungsgemäßen elektronischen Bauelements durch ein Druckverfahren mit einem anschließenden Sinterschritt oder Temperschritt hergestellt werden.

7. Verfahren zur Herstellung eines elektronischen Bauelements nach einem der Ansprüche 1 bis 5, bei dem die Strukturen eines erfindungsgemäßen elektronischen Bauelements durch ein Druckverfahren mit einem anschließenden Sinterschritt oder Temperschritt hergestellt und hieran anschließend mit einem Elektrolyten belegt werden.

8. Verfahren nach Anspruch 7, wobei die Nanopartikel direkt in einen flüssigen Elektrolyten dispergiert und hieran anschließend durch Spin-Coating oder mittels eines Druckverfahrens auf ein Substrat aufgebracht werden.

9. Verfahren nach einem der Ansprüche 7 oder 8, wobei ein flüssiger Elektrolyt eingesetzt wird, der, nachdem er auf das Substrat aufgebracht wurde, fest wird.

10. Verwendung eines elektronischen Bauelements nach einem der Ansprüche 1 bis 5 als Diode, Transistor, Spannungsinverter oder Sensor.

## Claims

1. Electronic component, comprising
two electrodes (1, 2), between which a layer (10) of nanoparticles is located, which are composed of an electrically conductive bond between a metal and an element from main group VI of the periodic table, wherein the dimensions of the majority of the nanoparticles range between 0.1 times and 10 times the screening length of the electrically conductive bond, and a dielectric which forms at least one common boundary area with at least a part of the nanoparticles from the layer (10), **characterised in that**
the layer (10) is formed by a printed nanoparticle film, the dielectric is present in the form of a solid or liquid electrolyte (30), which, with the nanoparticles of the layer (10) forms an interpenetrating network, and is in contact with a control electrode (31).

2. Electronic component with a layer (10) of nanoparticles according to claim 1, wherein the nanoparticles exhibit particle sizes from 5 nm to 500 nm, and pores are present between the nanoparticles in the layer (10) which exhibit a pore size distribution from 5 nm to 500 nm.

3. Electronic component according to claim 1 or 2, with nanoparticles from an electrically conductive metal oxide, metal sulphide, or metal selenide.

4. Electronic component according to claim 3, with nanoparticles of indium-tin oxide, fluorine-doped or antimony-doped tin (IV) oxide or aluminium-doped zinc oxide.

5. Electronic component according to claim 3, with nanoparticles of zinc oxide, titanium dioxide, zinc sulphide, or cadmium sulphide.

6. Method for producing an electronic component according to any one of claims 1 to 5, with which the structures of an electronic component according to the invention are produced by a printing process with a subsequent sintering step or tempering step.

7. Method for producing an electronic component according to any one of claims 1 to 5, with which the structures of an electronic component according to the invention are produced by a printing process with a subsequent sintering step or tempering step, and following this are coated with an electrolyte.

8. Method according to claim 7, wherein the nanoparticles are dispersed directly into a liquid electrolyte and, following this, are applied onto a substrate by spin-coating or by means of a printing process.

9. Method according to claim 7 or 8, wherein a liquid electrolyte is used which, after being applied onto the substrate, becomes solid.

10. Use of an electronic component according to any one of claims 1 to 5, as diode, transistor, voltage inverter, or sensor.

## Revendications

1. Composant électronique comprenant :
deux électrodes (1, 2) entre lesquels est positionnée une couche (10) de nanoparticules constituées d'un composé électriquement conducteur d'un métal avec un élément du groupe principal VI de la classification périodique des éléments, les dimensions de la plus grande partie des nanoparticules étant situées entre 0,1 fois et 10 fois la longueur de criblage du composé électriquement conducteur, ainsi qu'un diélectrique qui forme au moins une surface limite commune avec au moins une partie des nanoparticules de la couche (10),
**caractérisé en ce que**
la couche (10) est formée par un film nanoparticulaire imprimé, le diélectrique se présente sous la forme d'un électrolyte (30) solide ou liquide qui forme avec les nanoparticules de la couche (10) un réseau à interpénétration et vient en contact avec une électrode de commande (31).

2. Composant électronique ayant une couche de nanoparticules (10) conforme à la revendication 1,
dans lequel les nanoparticules ont une granulométrie de 5 nm à 500 nm et, la couche (10) comporte, entre les nanoparticules, des pores qui ont une répartition de dimensions de 5 nm à 500 nm.

3. Composant électronique conforme à la revendication 1 ou 2,
renfermant des nanoparticules en un oxyde métallique, un sulfure métallique ou un séléniure métallique électriquement conducteur.

4. Composant électronique conforme à la revendication 3,
renfermant des nanoparticules d'oxyde d'indium-étain, d'oxyde d'étain (IV) dopé au fluor ou à l'antimoine ou d'oxyde de zinc dopé à l'aluminium.

5. Composant électronique conforme à la revendication 3,
renfermant des nanoparticules en oxyde de zinc, en dioxyde de titane, en sulfure de zinc ou en sulfure de cadmium.

6. Procédé d'obtention d'un composant électronique conforme à l'une des revendications précédentes,
selon lequel les structures du composant électronique sont obtenues par un procédé d'impression suivi d'une étape de frittage ou d'une étape de recuit.

7. Procédé d'obtention d'un composant électronique conforme à l'une des revendications 1 à 5,
selon lequel les structures du composant électronique sont obtenues par un procédé d'impression suivi d'une étape de frittage ou d'une étape de recuit et sont ensuite garnies d'un électrolyte.

8. Procédé conforme à la revendication 7,
selon lequel les nanoparticules sont directement dispersées dans un électrolyte liquide, puis, sont appliquées par Spin-Coating ou au moyen d'un procédé d'impression sur un substrat.

9. Procédé conforme à l'une des revendications 7 et 8,
selon lequel on utilise un électrolyte liquide qui devient solide après qu'il ait été appliqué sur le substrat.

10. Utilisation d'un composant électronique conforme à l'une des revendications 1à 5 en tant que diode, transistor, inverseur de tension ou capteur.
